**Europäisches Patentamt**

**European Patent Office**

**Office européen des brevets**

(19)

(11) Veröffentlichungsnummer: **0 124 063**
**A1**

(12) ## EUROPÄISCHE PATENTANMELDUNG

(21) Anmeldenummer: **84104578.4**

(22) Anmeldetag: **24.04.84**

(51) Int. Cl.³: **G 01 B 7/06, C 23 C 15/00**

(30) Priorität: **29.04.83 DE 3315666**

(43) Veröffentlichungstag der Anmeldung: **07.11.84**
**Patentblatt 84/45**

(84) Benannte Vertragsstaaten: **AT BE CH DE FR GB IT LI LU NL SE**

(71) Anmelder: **Siemens Aktiengesellschaft, Berlin und München Wittelsbacherplatz 2, D-8000 München 2 (DE)**

(72) Erfinder: **Griessing, Jürgen, Dipl.-Phys., Schlehdornweg 6, D-8011 Baldham (DE)**
Erfinder: **Reindl, Werner, Kirchfeldstrasse 6, D-8025 Unterhaching (DE)**

(54) **Verfahren zur Messung des Auftrages und Abtrages von dünnen Schichten.**

(57) Zur Messung dient ein mobiles Meßobjekt bestehend aus einem oder mehreren Schwingquarzen auf einer Transporthalterung, das mit den Prozeßsubstraten in einer Prozeßkammer gleichwertig behandelt wird. Die Messung der Massenbelegung erfolgt nach einem Be- bzw. Entschichtungsprozeß. Durch die Beschichtung des oder der Quarze wird ihre Schwingfrequenz verändert und aus dieser Frequenzänderung die Auftrags- bzw. Abtragsrate berechnet.

**EP 0 124 063 A1**

SIEMENS AKTIENGESELLSCHAFT
Berlin und München

Unser Zeichen
VPA **83** P **1** 3 **1** 2 E

Verfahren zur Messung des Auftrages und Abtrages von
dünnen Schichten.

Die Erfindung betrifft ein Verfahren zur Messung der
Massenbelegung beim Auftragen bzw. Abtragen von dünnen
Schichten auf Substraten in der Vakuumbeschichtungs-
und Ätztechnik mit einer Meßeinrichtung in Form eines
Schwingquarzes, aus dessen Frequenzänderung die Schichtdickenänderung berechnet wird.

In der Vakuumbeschichtungstechnik ist beispielsweise eine
genaue Methode zur Schichtdickenmessung von unterschiedlichen Materialien erforderlich. Bei diesen Messungen
soll sowohl die mittlere Dicke als auch die Schichtverteilung über die gesamte Substratfläche erfaßt werden.

Bei der Herstellung von Mehrfachschichten von zum Beispiel
zwei Materialien auf einem Substrat ist es auch erforderlich, ein exaktes Konzentrationsverhältnis und eine sehr
enge Konzentrationsverteilung einzuhalten.

Die Beschichtungen erfolgen vorzugsweise durch Aufdampfen
bzw. Aufstäuben von dünnen Schichten in einer Prozeßkammer im Vakuum. Dabei werden reine Materialien (unter
anderem Metalle, Oxide, Legierungen) auf Substratträger
abgeschieden. Um die Schichtgleichmäßigkeit zu verbessern,
drehen bzw. rotieren die Substrate bei diesem Arbeitsvorgang.

In der Trockenätztechnik stellt sich das Problem, daß die
Ätzrate, Ätzverteilung und die Selektivität des Ätzver-

Wed 1 Plr/25.4.1983

0124063

fahrens zu bestimmen ist.

Es ist bekannt, mit der sogenannten Abtastmethode über eine Stufe die Schichtdicke zu messen. Dabei bedarf es im allgemeinen jedoch der aufwendigen Fotoätztechnik mit mehreren Verfahrensschritten, um zu einer Strukturierung zu kommen. Häufig treten Probleme auf, weil die zu messende Schicht bei der Stufenätzung nicht völlig selektiv vom Untergrund abgeätzt werden kann. In der Praxis ist diese Technik aufwendig und für eine exakte Schichtdickenmessung nicht ausreichend genau.

In der Dünnschichttechnik ist ein Verfahren zur Schichtdickenmessung bekannt, bei dem in der Prozeßkammer ein fest montierter Meßkopf mit einem Schwingquarz eine Referenz-Schichtdicke mißt. Durch die Beschichtung wird die Frequenz des Quarzes verändert und aus der Frequenzänderung die Schichtdicke errechnet. Nachteilig bei diesem Verfahren ist, daß nicht die auf dem Prozeßsubstrat beaufschlagte Schicht und deren Verteilung gemessen werden kann, da der Quarz ein Referenzelement darstellt und in der Prozeßkammer an einem anderen Ort angeordnet ist als die zu behandelnden Substrate.

Genaue Konzentrationsbestimmungen von Mehrfachschichten und deren Verteilung auf einem Substrat werden bislang durch sehr aufwendige Analyseverfahren, wie zum Beispiel Mikrosonde oder Röntgenfluoreszenz, bestimmt.

Der Erfindung liegt die Aufgabe zugrunde, das eingangs definierte Verfahren zu realisieren und damit ein vielseitig anwendbares Meßverfahren zu entwickeln, das sowohl den Auftrag als auch den Abtrag von Beschichtungen mißt. Die Messungen sollen an der jeweiligen Prozeßanlage schnell erfolgen und zu sehr genauen Meßergebnissen führen.

0124063

Diese Aufgabe wird nach der Erfindung dadurch gelöst, daß die Meßsonde exakt den gleichen Verfahrensprozeß in einer Prozeßkammer wie die Prozeßsubstrate durchläuft. Damit wird erreicht, daß die Meßeinrichtung mit dem Prozeßsubstrat in einem direkt vergleichbaren geometrischen Verhältnis steht und nicht in einer Referenzposition fest montiert ist. Durch einen fest angeordneten Quarz kann nämlich nie das Geschehen des Prozeßablaufs auf einer rotierenden Scheibe ermittelt werden, da die Abstrahlcharakteristik nicht homogen ist.

Die Messung der Massenbelegung erfolgt nach einem Be- bzw. Entschichtungsprozeß. Über die gemessene Massenbelegung kann die Abtrags- bzw. Auftragsrate berechnet werden.

Bei der Herstellung von Mehrfachschichten sind zuerst die exakten Prozeßdaten für die Einzelschichten zu ermitteln. Mit den daraus gewonnenen Einzeldaten wird der Gesamtprozeß zusammengestellt. Dieses Meßverfahren nach der Erfindung hat bei der Konzentrationsbestimmung zu reproduzierbar sehr genauen Meßergebnissen geführt.

Ein wesentlicher Vorteil der Erfindung ist es, daß nicht große Dickenunterschiede wie bei der Stufenmessung erforderlich sind, sondern bereits geringe Materialunterschiede zu sehr genauen Messungen führen.

Eine Anordnung zur Durchführung des erfindungsgemäßen Verfahrens besteht darin, daß die Meßsonde aus einer Transporthalterung besteht, die mit einem oder mehreren Schwingquarzen bestückt ist. Die Halterung ist dabei den geometrischen Anforderungen anzupassen. Die Quarze können je nach Aufgabenstellung individuell auf der Transporthalterung angeordnet werden.

Durch den Einsatz bei Be- und Entschichtungsverfahren sind vielseitige Anwendungsbereiche der Erfindung möglich.

0124063

Besonders vorteilhaft ist die Verwendung des Verfahrens zur Messung der Massenbelegung bei mehreren Quellen zur Einstellung der Maschinenparameter für eine bestimmte Materialkonzentration. Dabei wird zweckmäßigerweise durch Einzelfahrten festgestellt, auf welche Leistungen die einzelnen Quellen eingestellt werden müssen, das heißt, aufgrund der verschiedenen Massenbeschichtungen auf den einzelnen Quarzen wird ermittelt, wie die einzelnen Quellen für den simultanen Prozeß leistungsmäßig ausgerichtet werden müssen.

4 Patentansprüche

Patentansprüche

1. Verfahren zur Messung der Massenbelegung beim Auftragen bzw. Abtragen von dünnen Schichten auf Substraten in der Vakuumbeschichtungs- und Ätztechnik mit einer Meßeinrichtung in Form eines Schwingquarzes, aus dessen Frequenzänderung die Schichtdickenänderung berechnet wird, dadurch gekennzeichnet, daß die Meßsonde exakt den gleichen Verfahrensprozeß in einer Prozeßkammer wie die Prozeßsubstrate durchläuft.

2. Verfahren nach Anspruch 1, dadurch gekennzeichnet, daß die Meßeinrichtung nach einem Be- oder Entschichtungsprozeß den Prozeßablauf mißt.

3. Anordnung zur Durchführung des Verfahrens nach den Ansprüchen 1 und 2, dadurch gekennzeichnet, daß die Meßsonde aus einer Transporthalterung besteht, die mit einem oder mehreren Schwingquarzen bestückt ist.

4. Verwendung des Verfahrens nach den Ansprüchen 1, 2 und 3, dadurch gekennzeichnet, daß bei Beschichtungsverfahren mit mehreren Quellen über eine exakte Einstellung der Maschinenparameter eine bestimmte Materialkonzentration zu erreichen ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | FR-A-2 344 643 (HITACHI) <br> * Insgesamt * | 1-4 | G 01 B 7/06 <br> C 23 C 15/00 |
| | --- | | |
| X | FR-A-2 396 093 (HITACHI) <br> * Insgesamt * | 1-4 | |
| | --- | | |
| X | JAPANESE JOURNAL OF APPLIED PHYSICS, Band 21, Nr. 2, Teil 1, Februar 1982, Seiten 213-223, Tokyo, JP; E. MARUYAMA: "Amorphous built-in-field effect photoreceptors" <br> * Seiten 218,219 * | 1-4 | |
| | ----- | | |

| RECHERCHIERTE SACHGEBIETE (Int. Cl. 3) |
|---|
| G 01 B 7/00 <br> C 23 C 15/00 |

Der vorliegende Recherchenbericht wurde für alle Patentansprüche erstellt.

| Recherchenort <br> DEN HAAG | Abschlußdatum der Recherche <br> 06-08-1984 | Prüfer <br> BROCK T.J. |
|---|---|---|